# EUROPÄISCHE PATENTSCHRIFT

(11) **EP 1 085 381 B1**
(45) Veröffentlichungstag und Bekanntmachung des Hinweises auf die Patenterteilung: **05.04.2006**
(21) Anmeldenummer: 00203132.6
(22) Anmeldetag: 11.09.2000
(51) Int. Cl.: G03F 7/32

(54) **Entwickler für bestrahlte, strahlungsempfindliche Aufzeichnungsmaterialien**
Developer for radiation exposed photoimageable materials
Développateur pour matériaux photoimageables exposés aux radiations

(30) Priorität: 14.09.1999 US 395961
(43) Veröffentlichungstag der Anmeldung: 21.03.2001
(73) Patentinhaber: AGFA-GEVAERT, 2640 Mortsel (BE)
(72) Erfinder: Denzinger, Steffen, 55128 Mainz (DE); Dörr, Michael, 55128 Mainz (DE); Konrad, Klaus-Peter, 55457 Gensingen (DE); Elsässer, Andreas, 65510 Idstein (DE); Eckler, Paul, Princeton Jct.,NJ 08550-1936 (US)

(56) Entgegenhaltungen:
- EP-A- 0 367 049
- EP-A- 0 923 001

## Beschreibung

Die Erfindung betrifft einen Entwickler für bestrahlte, strahlungsempfindliche Aufzeichnungsmaterialien, der Wasser und mindestens eine in wäßriger Lösung alkalisch reagierende Verbindung enthält. Er ist besonders geeignet zum Entwickeln von strahlungsempfindlichen Aufzeichnungsmaterialien, aus denen Offsetdruckplatten hergestellt werden.

An einen wäßrig-alkalische Entwickler der eingangs genannten Art wird eine Reihe von Ansprüchen gestellt: Er soll ergiebig sein. Das bedeutet, die Entwicklungsleistung soll auch nach längerem Gebrauch und dadurch gestiegener Belastung durch abgelöste Schichtbestandteile möglichst wenig abnehmen. Die sogenannte "Tongrenze", bei der der Entwickler verbraucht ist und die Schicht an den Nichtbildstellen nur noch unvollständig ablöst, soll so hoch wie möglich liegen. Selbstverständlich soll er die Aufzeichnungsmaterialien möglichst schnell und vollständig entwickeln. Dies ist besonders wichtig bei der maschinellen Herstellung der Druckplatten in Verarbeitungsstraßen. Bedingt durch kurze Taktzeiten kann eine Entwicklungsdauer von deutlich weniger als 30 s notwendig sein.

Aus ökologischen und ökonomischen Gründen ist es von Vorteil, wenn der Entwickler in Form eines flüssigen Konzentrats angeboten werden kann, das erst der Verbraucher mit Wasser verdünnt. Die Härte des Wassers ist regional verschieden, was aber die Eigenschaften des gebrauchsfertigen Entwicklers nicht beeinflussen soll. Daraus resultiert die Forderung nach einer geringen Empfindlichkeit gegen Wasserhärte.

Beim Entwickeln sollen sich weder Schaum noch feste Niederschläge bilden. Schaum kann zum Überlaufen der Verarbeitungsanlage führen. Außerdem wird durch Schaumbildung das Pumpen und Umfüllen bei der Herstellung wie auch bei der Verwendung des Entwicklers erschwert. Letztere könnten die Entwicklungsgeräte verunreinigen und damit einen erhöhten Wartungsaufwand verursachen oder sich sogar auf dem entwickelten Aufzeichnungsmaterial absetzen.

Außerdem muß die mit Schichtresten beladene Entwicklerlösung mit den in der Verarbeitungsanlage verwendeten Gummierlösungen verträglich sein. Durch die unvermeidliche Verschleppung von belasteter Entwicklerlösung über durchlaufende Druckplatten kann es nach relativ kurzer Zeit zur Ansammlung von Schichtresten im nachgeschalteten Vorratsbehälter der Gummierlösung kommen. Im ungünstigsten Fall entstehen dadurch feste Niederschläge, die sich nach einer Phase der Anreicherung über das Walzensystem der Gummierstation auf der druckenden Oberfläche der entwickelten Druckplatte wieder absetzen ("redeponieren") und letztere dadurch unbrauchbar machen können.

In der EP-A 0 323 836 sind wäßrig-alkalische Entwickler für positiv und negativ arbeitende Aufzeichnungsmaterialien beschrieben. Sie enthalten neben einem alkalisch wirkenden Mittel einen Verdicker, der ihre Viskosität auf 5 bis 10.000 cps einstellt. Gegebenenfalls können die Entwickler auch organische Lösemittel wie Benzylalkohol oder Ethylenglykol-monophenylether enthalten. Entwickler für positiv arbeitende Aufzeichnungsmaterialien können darüber hinaus Tenside enthalten, insbesondere anionische oder amphotere Tenside. Als Verdicker dienen feine Silikatpulver oder wasserlösliche Polymere, wie Stärke, Gummi arabicum, Natriumalginat, Pektin, Viskose, Methylcellulose, Carboxymethylcellulose, Polyvinylalkohol, Polyvinylmethylether oder Polyvinylpyrrolidon.

Ein sehr spezieller wäßrig-alkalischer Entwickler für negativ arbeitende Aufzeichnungsmaterialien zur Herstellung von Offsetdruckplatten ist in der EP-A 0 602 736 offenbart. Er erlaubt besonders kurze Entwicklungszeiten und verhindert übermäßige Ablagerungen in den Verarbeitungsgeräten. Darüber hinaus soll er bereits gebildete Ablagerungen schnell wieder auflösen. Er enthält ein organisches Lösemittel, ein anionisches Tensid, ein Alkalimetall-tetraborat, ein Alkalisalz einer aliphatischen Monocarbonsäure, ein Alkalisalz einer aliphatischen Dicarbonsäure, ein Alkalimetall-citrat, ein Poly(alkylenglykol), ein Alkalimetallsalz einer hydroxylierten aromatischen Carbon- oder Sulfonsäure und ein alkalisches Puffersystem, das einen alkalischen pH-Wert gewährleistet.

Ein zur Herstellung von Negativ-Druckplatten geeigneter Entwickler ist auch Gegenstand der US-A 3 954 472. Er enthält Ammoniumsulfit und Polyvinylpyrrolidon gelöst in Wasser und einem Alkohol, insbesondere n-Propanol. Das Polyvinylpyrrolidon wirkt dabei als Gummierungsmittel.

Polyvinylpyrrolidon oder ein Copolymer mit Einheiten aus N-Vinyl-pyrrolidon wird auch in dem wäßrig-alkalischen Entwickler gemäß der DE-A 42 24 205 verwendet. Der Entwickler enthält daneben ein alkalisch wirkendes Mittel, wie NaOH, KOH, Na₂CO₃, K₂CO₃, Natrium- oder Kaliumsilikat, Trinatrium- oder Trikaliumphosphat. Gegebenenfalls kann noch ein Tensid vom Alkalimetallsulfat- oder Alkalimetallsulfonattyp, ein Antischaummittel sowie ein organisches Lösemittel, wie Benzylalkohol oder Ethylenglykol-monomethylether, -monoethylether, -monobutylether oder -monophenylether, zugefügt werden. Er ist speziell für die Entwicklung von Farbprüfmaterialien (= Color-Proof-Materialien) vorgesehen, wo er die Bildung von Farbschleiern in den Nichtbildbereichen verhindert.

In der EP-A 0 004 014 ist ein besonders ergiebiger Entwickler für Aufzeichnungsmaterialien mit belichteten, negativ arbeitenden Schichten aus Diazoniumsalz-polykondensationsprodukten und wasserunlöslichen organischen Polymeren offenbart. Er enthält ein anionisches Netzmittel, Polyvinylalkohol, Poly(N-Vinyl-N-methyl-acetamid), Benzylalkohol, Glycerintriacetat und einen Puffer, der einen pH-Wert im Bereich von 4 bis 8 gewährleistet Da in diesem Entwickler nur hochsiedende organische Lösemittel verwendet werden, bleibt seine Zusammensetzung auch bei längerem Stehen in offenen Behältern praktisch konstant.

Mit dem wäßrig-alkalischen Entwickler gemäß der EP-A 0 180 122 lassen sich belichtete, negativ arbeitende Kopierschichten besonders schnell und gut entwickeln. Er hat darüber hinaus eine hohe Standzeit, ist in automatischen Entwicklungsmaschinen einsetzbar und verhindert die Bildung von Fladen und Fädchen aus abgelösten Schichtbestandteilen. Er enthält neben Wasser und einem alkalisch reagierenden Mittel einen Komplexbildner, ein anionisches Tensid, eine Alkansäure oder deren Salz, eine Puffersubstanz und einen Emulgator, der bevorzugt Poly(N-Vinyl-N-methyl-acetamid), Polyvinylalkohol, Dextrin, Gummi arabicum oder ein Celluloseether ist.

Die genannten polymeren Emulgatoren bewirken zwar eine wesentliche Verbesserung der Entwicklereigenschaften, haben jedoch auch Nachteile. So bestimmen sie wesentlich die Viskosität, d.h. sie bewirken selbst dann eine relativ hohe Viskosität, wenn sie nur in geringen Mengen im Entwickler enthalten sind. Eine möglichst niedrige Grundviskosität und eine moderate Viskositätserhöhung bei zunehmender Belastung des Entwicklers durch abgelöste Schichtbestandteile ist jedoch notwendig, um einerseits die mechanische Belastung von Bauteilen der Verarbeitungsanlage (Pumpen, Schlauchverbindungen) gering zu halten und andererseits einer frühzeitigen Verschlammung im Entwicklungsteil der Verarbeitungsmaschine und damit einem erhöhten Reinigungsaufwand beim Entwicklerwechsel entgegenzuwirken. Mit den bekannten Emulgatoren wird stets nur ein Kompromiß erreicht. Durch den stark viskositätssteigemden Effekt der bekannten Emulgatoren ist ihr Anteil in der Entwicklerlösung beschränkt.

Mit den bisher bekannten Entwicklern ließen sich die genannten Forderungen - keine Bildung von Fladen oder Fädchen durch abgelöste Schichtbestandteile in der Entwicklerstation oder in der nachfolgenden Gummierstation der Druckplattenverarbeitungsmaschine, dabei gleichzeitig geringe Grundviskosität und geringe Viskositätszunahme bei wachsender Belastung - nicht alle gleichzeitig erfüllen. Es bestand daher die Aufgabe, einen entsprechend verbesserten Entwickler für strahlungsempfindliche Aufzeichnungsmaterialien zur Verfügung zu stellen.

Ein vielversprechender Ansatz zur Lösung des Problems ist bereits in der EP-A 923 001 beschrieben. Dort ist ein wäßrig-alkalischer Entwickler offenbart, der als Emulgator ein Copolymer enthält mit Einheiten aus mindestens einer hydrophoben Vinylverbindung, die Alkylreste mit bis zu 30 Kohlenstoffatomen aufweist, und mindestens einer hydrophilen, ethylenisch ungesättigten Carbonsäure, wobei ein Teil der Carboxygruppen in diesen Einheiten verestert ist mit Umsetzungsprodukten von (A) (C₁-C₃₀)Alkanolen, (C₈-C₂₅)Alkansäuren, (C₁-C₁₂)Alkylphenolen, Di(C₁-C₂₀)alkylaminen mit (B) (C₂-C₄)Alkylenoxiden oder Tetrahydrofuran, wobei das Molverhältnis (A): (B) im Bereich von 1 : 2 bis 1 : 50 liegt. Mit diesem Entwickler läßt sich die Aufgabe bereits weitgehend lösen, allein er schäumt zu stark. Schaumbildung erschwert die Handhabung von Entwicklern, insbesondere das Abfüllen, Umfüllen und Umpumpen. Es kann schließlich zu einem Überlaufen der Entwicklungsbäder in den Entwicklungsmaschinen führen. Es galt daher, den bekannten Entwickler so zu verbessem, daß er deutlich weniger schäumt.

Überraschenderweise ließ sich diese Aufgabe lösen mit emulgierend wirkenden Copolymeren, die denen in der EP-A 932 001 offenbarten strukturell ähnlich sind, in denen jedoch an die Stelle der dort beschriebenen Einheiten aus hydrophoben Vinylverbindungen mit aliphatischen Kohlenwasserstoffresten Einheiten aus hydrophoben Vinylverbindungen mit aromatischen Kohlenwasserstoffresten getreten sind.

Gegenstand der vorliegenden Erfindung ist somit ein Entwickler für bestrahlte, strahlungsempfindliche Aufzeichnungsmaterialien, der Wasser und mindestens eine in wäßriger Lösung alkalisch reagierende Verbindung enthält und dadurch gekennzeichnet ist, daß er mindestens ein als Emulgator wirkendes Copolymer enthält mit Einheiten aus
(I) mindestens einer hydrophoben Vinylverbindung, die mindestens einen gegebenenfalls substituierten, mono- oder bicyclischen (C₆ - C₁₄)Arylrest aufweist, und
(II) mindestens einer hydrophilen, ethylenisch ungesättigten Carbonsäure, wobei ein Teil der Carboxygruppen in diesen Einheiten verestert ist mit Umsetzungsprodukten von
   (A) (C₁-C₃₀)Alkanolen, (C₈-C₂₅)Alkansäuren, (C₁-C₁₂)Alkyl-phenolen, Di(C₁-C₂₀)alkylaminen mit
   (B) (C₂-C₄)Alkylenoxiden oder Tetrahydrofuran,
wobei das Molverhältnis (A): (B) im Bereich von 1 : 2 bis 1 : 50 liegt.

In einer bevorzugten Ausführungsform liegt das Molverhältnis (A): (B) im Bereich von 1 : 4 bis 1 : 10.

Bei der hydrophoben Vinylverbindung (I), die die mindestens einen gegebenenfalls substituierten, mono- oder bicyclischen (C₆ - C₁₄)Arylrest aufweist, handelt es sich bevorzugt um eine Verbindung mit einer gegebenenfalls substituierten Phenyl-oder einer Naphthylgruppe. Der bicyclische Arylrest ist nicht notwendig ein kondensierter Rest, er kann auch ein nicht-kondensierter Rest sein, beispielsweise ein Biphenyl-4-yl-Rest. Der aromatische Rest kann wiederum Teil einer Aralkylgruppe sein, worin der Alkylteil allgemein eine Kettenlänge von 1 bis 6 Kohlenstoffatomen hat und verzweigt oder unverzweigt sein kann. Mit besonderem Vorteil lassen sich Vinylaromaten einsetzen, insbesondere Styrol und α-Methyl-styrol. Von den substituierten Styrolen und α-Methyl-styrolen sind solche mit einem Alkyl-, Alkoxy-, Hydroxy- und/oder Arytoxy-Substituenten am aromatischen Ring bevorzugt. Daneben eignen sich als hydrophobe Vinylverbindung Allylbenzol, Phenyl(meth)acrylat, Benzyl(meth)acrylat, Phenethyl(meth)acrylat, Naphthyl(meth)acrylat, (2-Phenoxyethyl)-(meth)acrylat, (2-Naphthalin-1-oder -2-yloxy-ethyl)-(meth)acrylat, (3-Phenoxy-propyl)-(meth)acrylat, (3-Naphthalin-1- oder -2-yloxy-proyl)-(meth)acrylat, N-Phenyl-(meth)acrylamid, N-Benzyl-(meth)acrylamid, N-Phenethyl-(meth)acrylamid, N-Naphthyl-(meth)acrylamid, N-Vinyl-benzamid, Phenyl-vinyl-ether und Benzylvinyl-ether. Die Bezeichnung "....(meth)acrylat" steht hier wie auch im folgenden für "....acrylat und/oder methacrylat". Entsprechendes gilt für "...(meth)acrylamid" usw. Auch diese Verbindungen sind gegebenenfalls substituiert, insbesondere mit Halogenatomen (insbesondere Cl oder Br), mit (C₁ -C₆)Alkyl- oder (C₁ -C₆)Alkoxygruppen. Die Art der Substituenten ist keinen besonderen Einschränkungen unterworfen, sie sollten allerdings so gewählt sein, daß sie die Schaumbildung beim fertigen Copolymer nicht erhöhen, d.h. sie sollten beispielsweise keine ausgeprägten Tensideigenschaften bewirken, wie es beispielsweise langkettige Alkylreste mit 8 oder mehr Kohlenstoffatomen tun können. In der Regel enthält die hydrophoben Vinylverbindung (I) nicht mehr als 30 Kohlenstoffatome.

Bevorzugt sind jedoch Styrol, α-Methyl-styrol und substituierte Styrole (speziell Hydroxystyrole) und Benzyl(meth)acrylat. Es können auch Gemische von mehreren verschiedenen hydrophoben, Arylgruppen enthaltenden Vinylverbindungen eingesetzt werden.

Die ethylenisch ungesättigte Carbonsäure (II) ist bevorzugt eine α,β-ungesättigte Carbonsäuren mit 3 bis 8 C-Atomen. Es kann eine Mono-, Di- oder Tricarbonsäure sein, wobei (C₃-C₈)Monocarbonsäuren, wie Acrylsäure, Methacrylsäure oder Crotonsäure, und (C₄-C₈)Dicarbonsäuren, wie Maleinsäure, Itaconsäure, Methylenmalonsäure, Mesaconsäure oder Citraconsäure, bevorzugt sind. Bei der Herstellung der Copolymere können naturgemäß auch Säurederivate, insbesondere Säureanhydride, eingesetzt werden.

Geeignete (C₁-C₃₀)Alkanole (A) sind Methanol, Ethanol, Propanol, Isopropanol, Butanol, Isobutanol, *sec*.-Butanol, *tert*.-Butanol, Pentanol, Hexanol, 2-Ethyl-hexanol, Heptanol, Octanol, Decanol, Dodekanol, Tridecanol, Tetradecanol, Pentadecanol, Octadecanol, Eicosanol und Hexacosanol. Bevorzugt sind (C₁₀-C₁₅)-Alkanole, wie sie nach dem Oxoverfahren erhältlich sind (daher auch als "Oxoalkohole" bezeichnet).

Bevorzugte (C₈-C₂₅)Alkansäuren sind Octansäure (= Caprylsäure), Nonansäure (= Pelargonsäure), Decansäure (= Caprinsäure), Undecansäure, Dodecansäure (= Laurinsäure), Tridecansäure, Tetradecansäure (= Myristinsäure), Pentadecansäure, Hexadecansäure (= Palmitinsäure), Octadecansäure (= Stearinsäure), Eicosansäure (= Arachinsäure), Docosansäure (= Behensäure) und Tetracosansäure (= Lignocerinsäure).

Die (C₁-C₁₂)Alkyl-phenole (A) sind bevorzugt Methylphenol, Butylphenol, Isobutylphenol, Pentylphenol, Hexylphenol, Octylphenol, Nonylphenol, Decylphenol und Dodecylphenol, wobei sich die geradkettigen oder verzweigten Alkylgruppen vorzugsweise in *ortho-* oder *para*-Position zur phenolischen Hydroxygruppe befinden.

Geeignete Di(C₁-C₂₀)alkylamine (A) sind Dimethylamin, Ethyl-methyl-amin, Diethylamin, Dipropylamin, Ethyl-propyl-amin, Dibutylamin, Dipentylamin, Dioctylamin, Ethyl-octyl-amin, Didecylamin, Didodecylamin und Dioctadecylamin. Von diesen sekundären Aminen sind solche mit 8 bis 18 C-Atomen in jeder Alkylgruppe bevorzugt.

Als (C₂-C₄)Alkylenoxide (B) werden bevorzugt Ethylen- und Propylenoxid eingesetzt; aber auch Butylen- und Isobutylenoxid oder ein Gemisch davon sind verwendbar. Es ist auch möglich, die Umsetzung mit zwei oder mehr der genannten Alkylenoxide nacheinander durchzuführen, beispielsweise die Verbindungen (A) erst mit Ethylenoxid und dann mit Propylenoxid (oder umgekehrt) umzusetzen.

Von den Copolymeren sind solche bevorzugt, in denen 5 bis 50 %, besonders bevorzugt 10 bis 35 %, der Carboxygruppen der ethylenisch ungesättigten Carbonsäuren (II) verestert sind. Die Einheiten (I) und (II) sollten zusammen mindestens 50 mol-%, bevorzugt mindestens 70 mol-%, aller Einheiten im Copolymer ausmachen. Dabei sollten die Einheiten (II) einen Anteil von mindestens 5 mol-%, bevorzugt mindestens 10 mol-%, haben.

In einer bevorzugten Ausführungsform ist das als Emulgator wirkende Copolymer erhältlich durch Copolymerisation von (I)mindestens einer Verbindung mit einer gegebenenfalls substituierten Phenyl- oder einer Naphthylgruppe und
(IIa) mindestens einem ethylenisch ungesättigten Dicarbonsäureanhydrid mit 4 bis 8 C-Atomen, wobei das Molverhältnis (I) : (IIa) im Bereich von 7:3 bis 3:7 liegt, oder
(IIb) mindestens einer ethylenisch ungesättigten Monocarbonsäuren mit 3 bis 8 C-Atomen, wobei das Molverhältnis (I) : (IIb) im Bereich von 1:1 bis 1:5 liegt,
anschließender partieller Veresterung der Carboxygruppen des Copolymers mit Umsetzungsprodukten von (A) (C₁-C₃₀)Alkanolen, (C₈-C₂₂)Fettsäuren, (C₁-C₁₂)-Alkyl-phenolen oder sekundären (C₂-C₃₀)Aminen mit (B) mindestens einem (C₂-C₄)Alkylenoxid oder Tetrahydrofuran, wobei das Molverhältnis (A) : (B) im Bereich von 1:2 bis 1:50 liegt, und Hydrolyse der Anhydridgruppen des Copolymers zu Carboxygruppen oder deren Salzen (bevorzugt Erdalkali- oder Alkalimetallsalzen, insbesondere K- oder Na-Salzen), wobei die partielle Veresterung so weit geführt wird, daß zwischen 5 und 50% der Carboxygruppen des Copolymers verestert sind.

Die in dem erfindungsgemäßen Entwickler eingesetzten Copolymere sind auch durch Copolymerisation von (I) mit den Reaktionsprodukten von (IIa) oder (IIb) mit (A) und (B) im oben genannten Molverhältnis erhältlich. Die Copolymere können darüber hinaus bis zu 50 mol% an anderen Einheiten enthalten, insbesondere solchen aus Amiden monoethylenisch ungesättigter (C₃-C₈)Carbonsäuren, deren Amidgruppen der Formel

-CO-NR¹R²

entsprechen, worin
- R¹: eine (C₈-C₂₈)Alkylgruppe oder eine Gruppe der Formel RO-[CHR³-CHR⁴-O]ₙ₋₁-CHR³-CHR⁴- und
- R²: ein Wasserstoffatom oder eine der Gruppen R¹ bedeutet,
- R³, R⁴: gleich oder verschieden sind und ein Wasserstoffatom, eine Methyl- oder eine Ethylgruppe bedeuten,
- R: eine (C₁-C₂₈)Alkylgruppe und
- n: eine ganze Zahl von 2 bis 100 bedeutet.

Die in dem erfindungsgemäßen Entwickler eingesetzten Copolymere besitzen allgemein K-Werte von 6 bis 200, bevorzugt 10 bis 80 (bestimmt nach H. Fikentscher in 1%iger wäßriger Lösung bei 25°C und pH 7,5 in Form des Natriumsalzes), entsprechend einem mittleren Molekulargewicht M_{w} von 500 bis 500.000, bevorzugt 1.000 bis 150.000. Die Monomereinheiten sind darin in der Regel statistisch verteil; die Copolymere sind also keine Blockcopolymere.

Als Komponente (IIa) sind monoethylenisch ungesättigte Dicarbonsäureanhydride mit 4 bis 8 C-Atomen, wie Maleinsäureanhydrid, Itaconsäureanhydrid, Mesaconsäureanhydrid, Citraconsäureanhydrid oder Methylenmalonsäureanhydrid, insbesondere Malein- und Itaconsäureanhydrid, bevorzugt. Geeignete Bedingungen zur Herstellung der Copolymere sind ausführlich in der EP-A 0 367 049 beschrieben. Von den ethylenisch ungesättigten (C₃-C₈)Carbonsäuren (IIb) sind Acrylsäure und Methacrylsäure bevorzugt, da sie großtechnisch verfügbar sind.

Ihre spezifischen emulgierenden Eigenschaften erhalten die Copolymere erst durch die Teilveresterungen ihrer Carboxygruppen mit den genannten Umsetzungsprodukten aus den Verbindungen (A) und (B). Es handelt sich dabei bevorzugt um Veretherungsprodukte aus (C₁-C₃₀)Alkoholen oder sekundären (C₂-C₃₀)Aminen (A), an die Polyalkylenoxid-Ketten aus 3 bis 30 (C₂-C₄)Alkylenoxid-Einheiten (B), bevorzugt Ethylen- und Propylenoxid oder Mischungen der beiden, angelagert sind. Verbindungen dieser Art, die am Polyalkylenoxid-Kettenende eine OH-Gruppe tragen, sind als nichtionische Tenside gängige Handelsprodukte (beispielsweise Ethoxylate/Propoxylate von Fettalkoholen, -säuren, -amiden, -aminen).

Um zu gut wasserlöslichen Substanzen zu gelangen, werden die im partiell veresterten Copolymer nach der Hydrolyse verbliebenen Carboxylgruppen durch Umsetzung mit Alkali, Ammoniak und/oder Alkanolaminen neutralisiert, so daß letztendlich wäßrige Lösungen mit pH-Werten von 4 bis 10, vorzugsweise von 6 bis 8 erhalten werden. Zur Neutralisation werden bevorzugt wäßrige NaOH- oder KOH-Lösungen eingesetzt.

Der erfindungsgemäße Entwickler zeigt eine mindestens ebenso hohe Belastbarkeit wie der aus der EP-A 923 001 bekannte (d.h. er kann mindestens ebenso viele Schichtbestandteile aus den entwickelten Aufzeichnungsmaterialien aufnehmen, ohne daß feste Bestandteile ausfallen (insbesondere in Form von Fädchen) oder solche festen Bestandteile sich auf den bereits entwickelten Materialien absetzen (was zur Bildung von sogenannten "Redeposits" führt) bei einer gleichzeitig deutlich verminderten Neigung zum Schäumen.

### Allgemeine Synthesevorschrift für Copolymere mit Einheiten aus ethylenisch ungesättigten Dicarbonsäureanhydriden (IIa):

In einem mit Rührer, Thermometer, Kühler, Stickstoffein- und -auslaß sowie Dosiervorrichtungen versehenen Polymerisationsreaktor wurden eine aromatische Vinylverbindung (I) oder ein Gemisch aus aromatischen Vinylverbindungen (I) und ein ethylenisch ungesättigtes Dicarbonsäureanhydrid (IIa) (s. Tabelle 1) sowie Polyvinylethylether mit einem K-Wert von 50 vorgelegt und in einem schwachen Stickstoffstrom auf 100°C erhitzt. Sobald die Temperatur erreicht war, wurden innerhalb von 1 bis 3 Stunden 1 mol-% *tert*.-Butylperoxy-2-ethyl-hexanoat (30 Gew.-% in dem Olefin oder der Olefinmischung) zugegeben. Das Reaktionsgemisch wird noch weitere 2 bis 4 Stunden auf 100°C erhitzt. Man erhielt eine klare Lösung des Copolymers in dem Olefin. Nicht umgesetzte aromatische Vinylverbindung (I) wurde anschließend unter vermindertem Druck abdestilliert.

**Tabelle I**

| Polymer | Monomer I | Molanteil* | Monomer IIa | Molanteil | Mw ** |
|---|---|---|---|---|---|
| A | Styrol | 5 | Maleinsäureanhydrid | 5 | 3.000 |
| B | Benzylmethacrylat | 6 | Maleinsäureanhydrid | 5 | 7.000 |

| | | | | | |
|---|---|---|---|---|---|
| * Molarer Anteil an Monomereinheiten im Ausgangsmonomeren-Gemisch | | | | | |
| ** mittleres Molekulargewicht M_{w} bestimmt durch Gel-Permeations-Chromatographie (GPC) in N,N-Dimethyl-acetamid als Eluent gegen einen Polymethylmethacrylat-Standard. | | | | | |

### Synthesebeispiel für die partielle Veresterung der Copolymere aus den Komponenten (I) und (IIa) (Polymere 1-5):

Die oben beschriebenen Copolymere wurden mit einem Anlagerungsprodukt aus der Umsetzung von Ethylenoxid mit einem Oxoalkohol in Gegenwart von para-Toluolsulfonsäure innerhalb von 2 bis 12 Stunden unter Kochen am Rückfluß umgesetzt. Das Reaktionsgemisch wurde dann auf 100°C abgekühlt. Anschließend wurde Wasser und gegebenfalls wäßrige Alkali- oder Erdalkalilösung zugegeben und weitere 2 Stunden bei 50°C bis 70°C gerührt. Es entstanden dabei hellbraune, viskose Lösungen.

**Tabelle II**

| 1 | 2 | 3 | 4 | 5 | 6 | 7 | 8 |
|---|---|---|---|---|---|---|---|
| 1 | A | 25 | 1 mol C₁₃/C₁₅-Oxoalkohol + 7 mol Ethylenoxid (EO) | NaOH | 36,2 | 7,2 | 5.000 |
| 2 | A | 10 | 1 mol C₈-Oxoalkohol + 5 mol EO | KOH | 38,0 | 7,0 | 4.500 |
| 3 | A | 32,5 | 1 mol C₁₃/C₁₅-Oxoalkohol + 10 mol EO | Mg(OH) 2 | 48,7 | 7,2 | 6.000 |
| 4 | B | 15,0 | 1 mol C₁₀-Oxoalkohol + 8 mol EO | NaOH | 40,0 | 7,4 | 11.000 |
| 5 | B | 12,5 | 1 mol Ethanol + 12 mol EO | KOH | 35,0 | 7,3 | 9.000 |

Die Zahlen in der ersten Reihe der Tabelle bedeuten:
- 1: Polymer Nr.
- 2: Ausgangscopolymer (s. Tabelle 1)
- 3: Anteil der umgesetzten COOH-Gruppen [%]
- 4: Verbindung erhältlich durch Alkoxylierung von
- 5: eingesetzte Base
- 6: Feststoffgehalt der wäßrigen Lösung [%]
- 7: pH-Wert
- 8: mittleres Molekulargewicht M_{w} des Produktes

### Synthesebeispiel für Copolymere mit Monomereinheiten aus (IIb) (Polymer 6):

α-Methyl-styrol, Acrylsäure und das Umsetzungsprodukt aus 8 mol Ethylenoxid mit 1 mol C₁₃/C₁₅-Oxoalkohol und Acryloylchlorid wurden im Molverhältnis 5:3:2 in dem oben beschriebenen Polymerisationsreaktor auf 100°C erhitzt. Innerhalb von 3 Stunden wurde 1 mol-% *tert*.-Butylperoxy-2-ethyl-hexanoat (30 Gew.-% in α-Methyl-styrol) zudosiert und weitere 3 Stunden bei 100°C gerührt. Das überschüssige α-Methyl-styrol wurde dann unter vermindertem Druck abdestilliert und der Destillationsrückstand mit wäßriger Kaliumhydroxid-Lösung versetzt, so daß eine viskose Lösung mit einem Feststoffgehalt von 38,4% und einem pH von 7,0 resultierte. Das mittlere Molekulargewicht M_{w} (bestimmt durch GPC mit N,N-Dimethyl-acetamid als Eluent gegen Polymethylmethacrylat als Standard) betrug 15.500.

Der erfindungsgemäße wäßrig-alkalische Entwickler enthält in gebrauchsfertiger Form mindestens eines der beschriebenen, als Emulgator wirkenden Copolymere in einem Anteil von 0,1 bis 10,0 Gew.-%, insbesondere 0,2 bis 8,0 Gew.-% und bevorzugt 0,5 bis 6,0 Gew.-%, jeweils bezogen auf das Gesamtgewicht des gebrauchsfertigen Entwicklers.

Der Entwickler gemäß der vorliegenden Erfindung eignet sich besonders zum Entwickeln von Aufzeichnungsmaterialien mit einer negativ arbeitenden strahlungsempfindlichen Schicht. Er enthält dann zusätzlich noch mindestens ein mit Wasser mischbares organisches Lösemittel und mindestens eine oberflächenaktive Verbindung (Tensid).

Die alkalisch reagierende Verbindung ist bevorzugt ein Alkanolamin, ein Hydroxid, ein Phosphat oder ein Carbonat. Bevorzugte Alkanolamine sind Ethanolamin, Di-und Triethanolamin, Isopropanolamin, Diisopropanolamin sowie Tris-(hydroxymethyl)-aminomethan. Bevorzugte Hydroxide sind Alkali- und Erdalkalimetallhydroxide sowie Di-, Tri- und Tetra(C₁-C₁₀)alkylammoniumhydroxide. Bevorzugte Carbonate sind Natrium-, Kalium- und Ammoniumcarbonate oder -hydrogencarbonate. Von allen alkalisch reagierenden Verbindungen sind die Alkanolamine und Alkalimetallhydroxide am besten geeignet.

Der Anteil der alkalisch reagierenden Verbindung(en) ist auf die Art des Aufzeichnungsmaterials abzustimmen. Er liegt in der Regel bei 0,1 bis 20 Gew.-%, insbesondere 0,5 bis 10 Gew.-% und vorzugsweise 1,0 bis 5,0 Gew.-%, jeweils bezogen auf das Gesamtgewicht des gebrauchsfertigen Entwicklers. Bei flüssigen Konzentraten liegt der Anteil entsprechend höher. Im allgemeinen beträgt der pH-Wert des gebrauchsfertigen erfindungsgemäßen Entwicklers 8,0 bis 13,0, bevorzugt 8,5 bis 11,5.

Als "mischbar mit Wasser" wird im Zusammenhang mit der vorliegenden Erfindung ein organisches Lösemittel bezeichnet, das in der verwendeten Menge (bis zu 20 Gew.-%) bei einer Temperatur, bei der Entwickler normalerweise gelagert oder verwendet werden (etwa 0 bis 60 °C), mit Wasser eine einheitliche Lösung bildet. Besonders kurze Entwicklungszeiten werden erreicht durch Zusatz eines oder mehrerer der folgenden organischen Lösemittel: Alkohole, speziell Benzylalkohol, Ethylenglykolmonophenylether, 1-Phenylethanol, 2-Phenylethanol, Propylenglykolmonomethyl- und - phenylether, sowie Glycerin oder Glycerinacetate. Der Anteil an organischem Lösemittel im gebrauchsfertigen Entwickler beträgt zweckmäßig 0,5 bis 15,0 Gew.-%, insbesondere 1,0 bis 10,0 Gew.-% und bevorzugt 2,0 bis 6,0 Gew.-%, jeweils bezogen auf das Gesamtgewicht des Entwicklers. Da nur relativ geringe Anteile an organischem Lösemittel im Entwickler vorhanden sind, ändert sich seine Zusammensetzung während des Gebrauchs praktisch nicht. Er hat somit in den Entwicklungsgeräten eine verhältnismäßig lange Standzeit.

Als Tenside eignen sich im erfindungsgemäßen Entwickler viele anionische oberflächenaktive Mittel. Darüber hinaus können Gemische aus anionischen mit nichtionischen und/oder zwitterionischen oberflächaktiven Substanzen erfolgreich eingesetzt werden. Bewährt haben sich vor allem anionische Tenside wie Alkali-, vorzugsweise Natrium-, -octylsulfate, -dodecylbenzolsulfonate, -alkylphenolethersulfate, -naphthalinsulfonate, -sulfosuccinate und -alkyletherphosphate. Geeignete nichtionische Tenside stammen aus den Substanzklassen der (C₁₀-C₁₈)Fettalkoholethoxylate, Polyethylenglykole, Ethylenoxid-Propylenoxid-(Block-)Copolymerisate und Alkylphenolethoxylate sowie der zwitterionischen Tenside vom Betain- oder Sulfobetain-Typ und können 0 bis 80 Gew.-% der gesamten Tensidmenge ausmachen. Der Anteil der oberflächenaktiven Substanz(en) im dem Entwickler beträgt allgemein 0,2 bis 12,0 Gew.-%, bevorzugt 0,5 bis 8,0 Gew.-%, besonders bevorzugt 1,0 bis 6,0 Gew.-%, jeweils bezogen auf das Gesamtgewicht des Entwicklers.

Der erfindungsgemäße Entwickler kann je nach Art der zu verarbeitenden Aufzeichnungsmaterialien weitere Additive enthalten, insbesondere Puffersubstanzen, Komplexbildner (speziell solche, die Calcium binden), Entschäumer oder Sequestrierhilfsmittel.

Als Puffersubstanzen haben sich in dem erfindungsgemäßen Entwickler n-Alkansäuren mit 6 bis 12 C-Atomen und/oder deren Salze, besonders Capryl-, Pelargon-, Caprin- und Laurinsäure, bewährt. Im gebrauchsfertigen Entwickler können diese Säuren in einem Anteil von 0,5 bis 8,0 Gew.-%, insbesondere 1,0 bis 6,5 Gew.-% vorliegen, bezogen auf das Gesamtgewicht des Entwicklers.

Als puffernde Systeme sind grundsätzlich alle diejenigen geeignet, die vorzugsweise im pH-Bereich von 8 bis 13 wirksam sind. Neben den genannten n-Alkansäuren und deren Salzen werden vor allem die allgemein zugänglichen Puffersubstanzen aus der Gruppe der Carbonate, Phosphate, Borate, Alkalisalze des Glycins und Amine verwendet. Sehr gebräuchliche Puffersysteme sind beispielsweise Mischungen aus Carbonat/Hydrogencarbonat oder Phosphat/ Hydrogenphosphat.

Als Komplexbildner sind die Salze niedermolekularer Phosphate, sogenannte Oligophosphate, mit 2 bis 10, vorzugsweise 2 bis 6, insbesondere 2 bis 4, Phosphoreinheiten einsetzbar. Besonders bevorzugt sind die Alkalisalze, insbesondere die Natrium- und Kaliumsalze, darunter z. B. Tetranatriumdiphosphat, Pentanatriumtriphosphat, Pentakaliumtriphosphat und Hexanatriumtetraphosphat. Gute Ergebnisse zeigen auch Alkalisalze, vorzugsweise Natriumsalze, der Nitrilotriessigsäure und der Ethylendiamintetraessigsäure, sowie Tris-hydroxymethylaminomethan. Der Gehalt an Komplexbildnern im gebrauchsfertigen Entwickler beträgt zweckmäßig 0,1 bis 5,0 Gew.-%, insbesondere 0,5 bis 4,0 Gew.-% und vorzugsweise 1,0 bis 3,0 Gew.-%.

Der Wasseranteil in dem Entwickler besteht vorzugsweise aus entionisiertem Wasser und beträgt in der gebrauchsfertigen Form 70 bis 95 Gew.%, bevorzugt 75 bis 90 Gew.-%.

Darüber hinaus kann der erfindungsgemäße Entwickler auch als Konzentrat formuliert werden. Der Anteil an nichtwäßrigen Komponenten ist darin bis zum Dreifachen der genannten Mengen gesteigert. Auch solche Konzentrate zeigen keine störende Geruchsbelästigung, und es treten auch nach Lagerung bei Temperaturen um den Gefrierpunkt keine Ausfällungen auf.

In den Geräten zur Entwicklung von Aufzeichnungsmaterialien sind üblicherweise Entwickler-, Spül- und Gummierstation hintereinander geschaltet. Mit steigender Belastung des Entwicklers mit Schichtbestandteilen kommt es zu einer langsameren und nicht mehr vollständigen Aufentwicklung. Beim Spülen ist es kaum zu vermeiden, daß wirksame Entwicklerbestandteile selektiv entfernt werden, so daß Schichtbestandteile aus der verschleppten Entwicklerlösung an der Oberfläche des Aufzeichnungsmaterials in agglomerierter Form adsorbiert werden und sich dort als unerwünschte Verunreinigungen bemerkbar machen können. Diese adsorbierten Schichtbestandteile werden von der Gummierlösung nicht aufgelöst und weggespült, sondem nur von der Trägeroberfläche als Häutchen abgehoben ("Fädchenbildung"). Dieses Phänomen wird durch den erfindungsgemäßen Entwickler wirkungsvoll verzögert, ohne daß gleichzeitig mit einer erheblichen Erhöhung der Entwicklerviskosität bei zunehmender Belastung mit Schichtbestandteilen zu rechnen ist, was wiederum dazu beiträgt, die Menge an verschlepptem Entwickler geringzuhalten.

Der erfindungsgemäße Entwickler eignet sich grundsätzlich für die Verarbeitung einer Reihe von positiv und negativ arbeitenden Aufzeichnungsmaterialien. Dabei können die negativ arbeitenden Materialien entsprechend der Art der strahlungsempfindlichen Schicht eingeteilt werden in solche
1. mit einer negativ arbeitenden Schicht auf Basis von Diazoniumsalz-Polykondensationsverbindungen,
2. mit einer negativ arbeitenden Schicht, die radikalisch polymerisierbare, olefinisch ungesättigte Verbindungen und Photopolymerisationsinitiatoren enthält, und
3. die auf einer Kombinationen der unter 1. und 2. genannten Prinzipien aufbauen.

Eine negativ arbeitende Schicht auf Basis von Diazoniumsalz-Polykondensationsverbindungen enthält beispielsweise Kondensationsprodukte von Diphenylamin-4-diazoniumsalzen mit Aldehyden, bevorzugt Formaldehyd. Mit besonderem Vorteil werden Mischkondensationsprodukte verwendet, die außer den Diazoniumsalz-Einheiten noch andere, nicht lichtempfindliche Einheiten enthalten, die von kondensationsfähigen Verbindungen, insbesondere aromatischen Aminen, Phenolen, Phenolethem, aromatischen Thioethem, aromatischen Kohlenwasserstoffen, aromatischen Heterocyclen und organischen Säureamiden abgeleitet sind. Geeignete Diazoniumsalz-Kondensationsprodukte dieser Art sind in den DE-A 20 24 244 und 27 39 774 beschrieben.

Zur Stabilisierung des lichtempfindlichen Gemisches ist es vorteilhaft, diesem eine Verbindung mit Säurecharakter zuzusetzen. In Betracht kommen Mineralsäuren und starke organische Säuren, von denen Phosphorsäure, Schwefelsäure, Perchlorsäure, Borsäure oder *para*-Toluolsulfonsäure bevorzugt werden. Eine besonders gut geeignete Säure ist die *ortho*-Phosphorsäure.

Ein weiterer Hauptbestandteil der negativ arbeitenden Schichten vom Typ 1 ist mindestens ein nicht lichtempfindliches polymeres Bindemittel mit seitenständigen Carboxygruppen, das in wäßrig-alkalischen Lösungen löslich oder mindestens quellbar ist. Dieses Bindemittel kann beispielsweise das Umsetzungsprodukt eines intramolekularen Anhydrids einer organischen Polycarbonsäure mit einem Hydroxygruppen enthaltenden synthetischen Polymer sein, das keine weiteren zur Umsetzung mit Säureanhydriden befähigten funktionellen Gruppen enthält. Funktionalisierte Bindemittel dieser Art sind in der DE-A 34 04 366 ausführlich beschrieben.

Den lichtempfindlichen Gemischen können ferner Weichmacher, Haftvermittler, Farbstoffe, Pigmente und photochemische Farbbildner zugesetzt sein.

Die negativ arbeitende Schicht vom Typ 2 enthält bevorzugt eine Kombination aus einem radikalisch polymerisierbaren, ethylenisch ungesättigten Monomer, insbesondere einem Acryl- oder Methacrylsäureester eines mehrwertigen Alkohols, und einem Photoinitiator. In diesen Schichten werden als alkalilösliche Bindemittel bevorzugt Polykondensate oder Polymere mit seitenständigen Carboxygruppen verwendet.

Vorzugsweise sind negativ arbeitende Schichten durch eine Deckschicht ("overcoat") geschützt, insbesondere vor dem Zutritt von Luftsauerstoff. Dazu enthält die Deckschicht üblicherweise Polymere, die eine verminderte Sauerstoffdurchlässigkeit bewirken. Besonder geeignet für diesen Zweck sind Polyvinylalkohol, Polyvinylpyrrolidon oder Gelatine.

Der erfindungsgemäße Entwickler ist auch für Aufzeichnungsmaterialien mit einer positiv arbeitenden strahlungsempfindlichen Schicht geeignet. Der Anteil des organischen Lösemittels muß dann allerdings relativ gering sein, damit die Bildbereiche nicht zu stark angegriffen werden.

Als Trägermaterial für Schichten mit einer Dicke unter ca. 10 µm werden meist Metalle verwendet. Für Offsetdruckplatten nimmt man gewöhnlich walzblankes, mechanisch und/oder elektrochemisch aufgerauhtes und gegebenenfalls anodisiertes Aluminium, das zudem noch chemisch (beispielsweise mit Polyvinylphosphonsäure, Silikaten, Phosphaten oder Hexafluorozirkonaten) vorbehandelt sein kann.

Die Beschichtung des Trägermaterials erfolgt in bekannter Weise durch Aufschleudern, Sprühen, Tauchen, Walzen, mittels Breitschlitzdüsen, Rakeln oder durch Gießer-Antrag.

Nach dem Auftragen der Schicht wird das Aufzeichnungsmaterial je nach Schichttyp bildmäßig und gegebenenfalls vollflächig bestrahlt. Übliche Strahlungsquellen sind anwendungsbedingt z. B. Röhrenlampen, Xenonimpulslampen, metallhalogeniddotierte Quecksilberdampf-Hochdrucklampen und Kohlebogenlampen. In automatischen Verarbeitungsanlagen sind Laser, wie Argon- oder Krypton-lonen-Laser bevorzugt. Auch Elektronen- oder Röntgenstrahlung kann zur Bilderzeugung verwendet werden.

Die anschließende Entwicklung mit den vorgenannten Entwicklern erfolgt meist in Sprüh-, Stau- oder Tauchbad-Entwicklungsgeräten bei Temperaturen von 15 bis 50°C, bevorzugt 18 bis 40°C. Die Entwicklungsdauer beträgt im allgemeinen 5 s bis 1 min, bevorzugt 10 bis 40 s.

An die Entwicklung können sich weitere Verarbeitungsschritte anschließen. Beispielsweise können Druckplatten mit einer (sauren) Hydrophilierungslösung behandelt oder mit einer Konservierungsschicht versehen werden. Zur Erhöhung der Widerstandsfähigkeit beim Druck sowie der Resistenz gegen Auswaschmittel, Korrekturmittel und UV-härtbare Druckfarben können die entwickelten Platten kurzzeitig erhitzt werden. Vor dem Erhitzen können auch sogenannte Einbrenngummierungen aufgetragen werden.

Die folgenden Ausführungsbeispiele sollen die Erfindung erläutern. Gt bedeutet Gewichtsteil(e). Prozente sind Gewichtsprozente, soweit nicht anders angegeben.

### A) Negativ arbeitendes Aufzeichnungsmaterial (Diazo):

Eine Beschichtungslösung aus

| | |
|---|---|
| 1,50 Gt | eines Polymeren, hergestellt durch Erhitzen einer Lösung eines Polyvinylbutyrals (enthält 71 Gew.% Vinylbutyral-, 3 Gew.% Vinyl-acetat- und 26 Gew.-% Vinylalkohol-Einheiten; Molekulargewicht M_{w} 70.000 bis 80.000) mit Maleinsäureanhydrid und Triethylamin in Methylethylketon unter Rückfluß, |
| 1,00 Gt | eines Diazoniumsalz-Polykondensationsproduktes aus 1 mol 3-Methoxy-diphenylamin-4-diazoniumsulfat und 1 mol 4,4'-Bis-methoxymethyl-diphenylether, ausgefällt als Mesitylensulfonat, |
| 0,09 Gt | Victoriareinblau FGA (Basic Blue 81), |
| 0,07 Gt | Benzolphosphonsäure, |
| 0,10 Gt | eines Kieselgelfüllstoffs mit einer mittleren Korngröße von 3 µm und |
| 97,24 Gt | eines Gemisches aus Tetrahydrofuran und Ethylenglykolmono-methylether (Mischungsverhältnis von THF : EGME = 40:60) |

wurde auf eine in Salzsäure aufgerauhte, in Schwefelsäure anodisierte und mit einer wäßrigen Polyvinylphosphonsäure-Lösung nachbehandelte Aluminiumfolie so aufgetragen, daß nach 2 min Trocknen bei 100°C das Schichtgewicht 1,0 g/m² betrug.

Mit der Beschichtungslösung hergestellte negativ arbeitende Aufzeichnungsmaterialien wurden in einem Kontaktkopierrahmen durch eine Negativ-Filmvoriage unter einer 5-kW-Metallhalogenidiampe im Abstand von 110 cm 30 s lang belichtet und dann in einem Sprüh-Entwicklungsgerät bei 24°C und einer Verarbeitungsgeschwindigkeit von 1,4 m/min (= 20 s Entwicklungszeit) entwickelt. Die Gummier station wurde mit einer handelsüblichen Gummierung gefüllt (AGFA ®Ozasol RC 795).

### B) Entwickler:

In Tabelle IIIa werden verschiedene Entwickler verglichen. Die Entwickler A, B und G dienen zu Vergleichszwecken, da sie andere polymere Emulgatoren als die erfindungsgemäßen Entwickler enthalten.

Tabelle IIIb enthält die Versuchsergebnisse im Vergleich. Die mit dem erfindungsgemäßen Entwickler entwickelten Platten waren in allen Fällen frei von Schleier, die Volltöne ohne Ausbrüche oder sonstige Schädigungen durch Schichtabtrag wiedergegeben, das 60er Raster mit einer Flächendeckung von 2 bis 98 %. Entwickelt wurde jeweils bis zu einer Endbelastung von 20 m²/l.

Ausgewertet wurden daneben folgende Meßgrößen:
- wie schnell der Schaum nach seiner Bildung wieder zerfällt (bestimmt anhand der Schaumzahlen nach 10 s und nach 60 s)
- wie viele Quadratmeter an Plattenfläche sich pro Liter an Entwickler problemlos entwickeln lassen, bevor eine Redeposit-Bildung eintritt

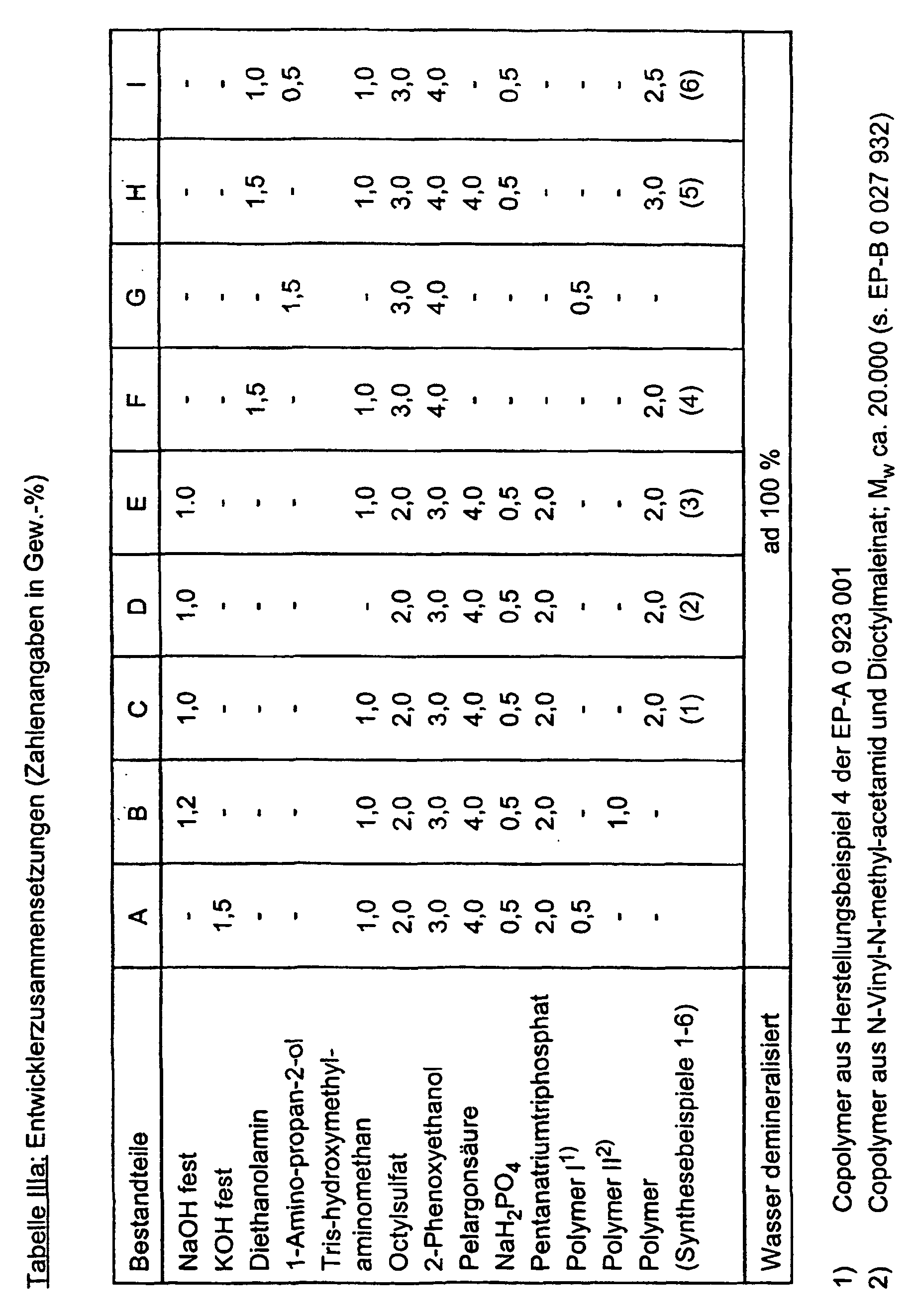

**Tabelle IIIb:**

| Entwicklerformulierung | Schaumzahl [%] | | redepositfrei entwickelbare Plattenfläche [m²/l] |
|---|---|---|---|
| | nach 10 sec. | nach 60 sec. | |
| A* | 36 | 64 | 16,5 |
| B* | 35 | 67 | 12,5 |
| C | 80 | 92 | 17,0 |
| D | 84 | 95 | 16,5 |
| E | 70 | 84 | 15,5 |
| F | 80 | 92 | 16,0 |
| G* | 34 | 62 | 16,5 |
| H | 82 | 94 | 15,5 |
| I | 76 | 88 | 16,0 |

| | | | |
|---|---|---|---|
| * Vergleichsbeispiele | | | |

Die Schaumzahl wird bestimmt, indem man exakt 50 ml des Entwicklers in einem verschließbaren 100 ml-Meßzylinder abfüllt, den Meßzylinder verschließt und ihn dann fünfmal durch Umschwenken kräftig schüttelt. Unmittelbar danach (d.h. bei t = 0 sec) wird das gesamte Volumen des Meßzylinders durch Flüssigkeit und Schaum ausgefüllt; dies entspricht einer Schaumzahl von 0 %. Nach 10 sec und nach 60 sec wird das Gesamtvolumen von Flüssigkeit und Schaum bestimmt. Wird wieder das Ausgangsvolumen von 50 ml erreicht, so ist der gesamte Schaum zerfallen, die Schaumzahl ist dann 100 %.

Tabelle IIIb zeigt deutlich, daß der erfindungsgemäße Entwickler eine deutlich geringere Neigung zur Schaumbildung zeigt und damit in der Praxis wesentlich einfacher zu handhaben ist.

## Patentansprüche

1. Entwickler für bestrahlte, strahlungsempfindliche Aufzeichnungsmaterialien, der Wasser und mindestens eine in wäßriger Lösung alkalisch reagierende Verbindung enthält, **dadurch gekennzeichnet, daß** er mindestens ein als Emulgator wirkendes Copolymer mit Einheiten enthält aus
(I) mindestens einer hydrophoben Vinylverbindung, die mindestens einen gegebenenfalls substituierten, mono- oder bicyclischen (C₆ - C₁₄)Arylrest aufinreist, und
(II) mindestens einer hydrophilen, ethylenisch ungesättigten Carbonsäure, wobei ein Teil der Carboxygruppen in diesen Einheiten verestert ist mit Umsetzungsprodukten von
(A) (C₁-C₃₀)Alkanolen, (C₈-C₂₅)Alkansäuren, (C₁-C₁₂)Alkyl-phenolen, Di(C₁-C₂₀)alkylaminen mit
(B) (C₂-C₄)Alkylenoxiden oder Tetrahydrofuran
wobei das Molverhältnis (A) : (B) im Bereich von 1 : 2 bis 1 : 50 liegt.

2. Entwickler gemäß Anspruch 1, **dadurch gekennzeichnet, daß** 5 bis 50 %, besonders bevorzugt 10 bis 35 %, der Carboxygruppen der ethylenisch ungesättigten Carbonsäuren(II) verestert sind.

3. Entwickler gemäß Anspruch 1 oder 2, **dadurch gekennzeichnet, daß** die Einheiten (I) und (II) zusammen mindestens 50 mol%, bevorzugt mindestens 70 mol-%, aller Monomereinheiten im Copolymer ausmachen, wobei die Einheiten (II) einen Anteil von mindestens 5 mol-%, bevorzugt mindestens 10 mol-%, ausmachen.

4. Entwickler gemäß einem oder mehreren der Ansprüche 1 bis 3, **dadurch gekennzeichnet, daß** das als Emulgator wirkende Copolymer erhältlich ist durch Copolymerisation von (I) mindestens einer Verbindung mit einer gegebenenfalls substituierten Phenyl- oder einer Naphthylgruppe und
(IIa) mindestens einem ethylenisch ungesättigten Dicarbonsäureanhydrid mit 4 bis 8 C-Atomen, wobei das Molverhältnis (I) : (IIa) im Bereich von 7:3 bis 3:7 liegt, oder
(IIb) mindestens einer ethylenisch ungesättigten Monocarbonsäure mit 3 bis 8 C-Atomen, wobei das Molverhältnis (I) : (IIb) im Bereich von 1:1 bis 1:5 liegt,
anschließender partieller Veresterung des Copolymers mit Umsetzungsprodukten von
(A) (C₁-C₃₀)Alkanoten, (C₈-C₂₂)Fettsäuren, (C₁-C₁₂)Alkyl-phenolen oder sekundären (C₂-C₃₀)Aminen mit
(B) mindestens einem (C₂-C₄)Alkylenoxid oder Tetrahydrofuran wobei das Molverhältnis (A) : (B) im Bereich von 1:2 bis 1:50 liegt,
und Hydrolyse der Anhydridgruppen der Copolymere zu Carboxygruppen oder deren Salzen, wobei die partielle Veresterung der Copolymere so weit geführt wird, daß zwischen 5 und 50% der Carboxygruppen des Copolymers verestert sind.

5. Entwickler gemäß einem oder mehreren der Ansprüche 1 bis 4, **dadurch gekennzeichnet, daß** das Molverhältnis (A) : (B) im Bereich von 1 : 4 bis 1 : 10 liegt.

6. Entwickler gemäß einem oder mehreren der Ansprüche 1 bis 5, **dadurch gekennzeichnet, daß** das als Emulgator wirkende Copolymer zusätzlich bis zu 50 mol-% an Einheiten enthält aus Amiden von monoethylenisch ungesättigten (C₃-C₈)Carbonsäuren, deren Amidgruppen der Formel
-CO-N(R¹)(R²),
entsprechen, worin
R¹ eine (C₈-C₂₈)Alkylgruppe oder eine Gruppe der Formel RO-[CHR³-CHR⁴-O]ₙ₋₁-CHR³-CHR⁴- und
R² ein Wasserstoffatom oder eine der Gruppen R¹ bedeutet,
R³, R⁴ gleich oder verschieden sind und ein Wasserstoffatom, eine Methyl- oder eine Ethylgruppe bedeuten,
R eine (C₁-C₂₈)Alkylgruppe und
n eine ganze Zahl von 2 bis 100 bedeutet.

7. Entwickler gemäß einem oder mehreren der Ansprüche 1 bis 6, **dadurch gekennzeichnet, daß** die Copolymere ein mittleres Molekulargewicht M_{w} von 500 bis 500.000, bevorzugt von 1.000 bis 150.000, aufweisen.

8. Entwickler gemäß einem oder mehreren der Ansprüche 1 bis 7, **dadurch gekennzeichnet, daß** der Anteil der Copolymere 0,1 bis 10,0 Gew.-%, bevorzugt 0,2 bis 8,0 Gew.-%, besonders bevorzugt 0,5 bis 6,0 Gew.-% beträgt, jeweils bezogen auf das Gesamtgewicht des Entwicklers.

9. Entwickler gemäß einem oder mehreren der Ansprüche 1 bis 8, **dadurch gekennzeichnet, daß** er zusätzlich ein mit Wasser mischbares organisches Lösemittel und mindestens eine oberflächenaktive Verbindung, gegebenenfalls auch Puffersubstanzen, Komplexbildner und/oder Antischaummittel enthält.

10. Entwickler gemäß einem oder mehreren der Ansprüche 1 bis 9, **dadurch gekennzeichnet, daß** der Anteil des alkalisch wirkenden Mittels 0,1 bis 20 Gew.-%, bevorzugt 0,5 bis 10 Gew.-%, besonders bevorzugt 1,0 bis 5,0 Gew.-% beträgt, jeweils bezogen auf das Gesamtgewicht des Entwicklers, wobei das alkalisch wirkende Mittel bevorzugt ein Alkanolamin, ein Hydroxid oder ein Carbonat ist, besonders bevorzugt Ethanolamin, Di- oder Triethanolamin, Isopropanolamin, Diisopropanolamin oder ein Alkali- oder Erdalkalimetallhydroxid.

11. Entwickler gemäß einem oder mehreren der Ansprüche 1 bis 10, **dadurch gekennzeichnet, daß** sein pH-Wert bei 8,0 bis 13,0, bevorzugt bei 8,5 bis 11,5, liegt.

12. Entwickler gemäß Anspruch 9, **dadurch gekennzeichnet, daß** der Anteil des mit Wasser mischbaren organischen Lösungsmittels 0,5 bis 15,0 Gew.-%, bevorzugt 1,0 bis 10,0 Gew.-%, besonders bevorzugt 2,0 bis 6,0 Gew.-%, beträgt, jeweils bezogen auf das Gesamtgewicht des Entwicklers, wobei das mit Wasser mischbare organische Lösungsmittel bevorzugt Benzylalkohol, Ethylenglykolmonophenylether, 1-Phenyl-ethanol, 2-Phenyl-ethanol oder Propylenglykolmonomethyl- und -phenylether ist.

13. Entwicklergemisch gemäß Anspruch 9, **dadurch gekennzeichnet, daß** der Anteil der oberflächenaktiven Verbindung(en) 0,2 bis 12,0 Gew.-%, bevorzugt 0,5 bis 8,0 Gew.-%, besonders bevorzugt 1,0 bis 6,0 Gew.-% beträgt, jeweils bezogen auf das Gesamtgewicht des Entwicklers, wobei die oberflächenaktive Verbindung bevorzugt ein anionisches Tensid ist, besonders bevorzugt ein Alkali-, vorzugsweise Natrium-, -octylsulfat, -dodecylbenzolsulfonat, -alkylphenolethersulfat, -naphthalinsulfonat, -sulfosuccinat, und/oder- alkyletherphosphat.

14. Verwendung des Entwicklers gemäß den Ansprüchen 1 bis 13 zur Entwicklung von Aufzeichnungsmaterialien mit einer bestrahlten, strahlungsempfindlichen, negativ arbeitenden Schicht, wobei die negativ arbeitende Schicht als strahlungsempfindliche Komponente vorzugsweise (a) eine Diazoniumsalz-Polykondensationsverbindung, (b) eine Kombination aus radikalisch polymerisierbaren, ethylenisch ungesättigten Verbindungen und Photoinitiatoren oder (c) eine Mischung aus (a) und (b) enthält.

15. Verwendung gemäß Anspruch 14, **dadurch gekennzeichnet, daß** die negativ arbeitende Schicht ein Bindemittel enthält, bevorzugt ein Umsetzungsprodukt eines intramolekularen Anhydrids einer organischen Polycarbonsäure mit einem Hydroxylgruppen enthaltenden synthetischen Polymer, das keine weiteren zur Umsetzung mit Säureanhydriden befähigten funktionellen Gruppen enthält.

## Revendications

1. Révélateur pour des matériaux d'enregistrement photosensibles exposés, qui contient de l'eau et au moins un composé réagissant à la manière des alcalis dans une solution aqueuse, **caractérisé en ce qu'**il contient au moins un copolymère faisant office d'émulsifiant, comprenant des unités choisies parmi le groupe constitué par
(I) au moins un composé vinyle hydrophobe qui présente au moins un radical aryle en C₆-C₁₄ monocyclique ou bicyclique, le cas échéant substitué, et
(II) au moins un acide carboxylique hydrophile à insaturation éthylénique, une partie des groupes carboxyle dans ces unités étant estérifiés avec des produits réactionnels de
(A) des alcanols en C₁-C₃₀, des acides alcanoïques en C₈-C₂₅, des alkyl(en C₁-C₁₂)phénols, des dialkyl(en C₁-C₂₀) amines, avec
(B) des oxydes d'alkylènes en C₂-C₄ ou du tétrahydrofuranne,
le rapport molaire (A) : (B) se situant dans la plage de 1 : 2 à 1 : 50.

2. Révélateur selon la revendication 1, **caractérisé en ce que** les groupes carboxyle des acides carboxyliques (II) à insaturation éthylénique sont estérifiés à concurrence de 5 à 50 %, de manière particulièrement préférée à concurrence de 10 à 35 %.

3. Révélateur selon la revendication 1 ou 2, **caractérisé en ce que** les unités (I) et (II) représentent ensemble au moins 50 mol %, de préférence au moins 70 mol % de toutes les unités monomère dans le copolymère, les unités (II) représentant une fraction d'au moins 5 mol %, de préférence d'au moins 10 mol %.

4. Révélateur selon une ou plusieurs des revendications 1 à 3, **caractérisé en ce qu'**on obtient le copolymère faisant office d'émulsifiant par copolymérisation de (I) au moins un composé contenant un groupe phényle le cas échéant substitué ou un groupe naphtyle, et
(IIa) au moins un anhydride d'acide dicarboxylique à insaturation éthylénique contenant de 4 à 8 atomes de carbone, le rapport molaire (I) : (IIa) se situant dans la plage de 7 : 3 à 3 : 7, ou
(IIb) au moins un acide monocarboxylique à insaturation éthylénique contenant de 3 à 8 atomes de carbone, le rapport molaire (I) : (IIb) se situant dans la plage de 1 : 1 à 1 : 5,
et ensuite par estérification partielle du copolymère avec des produits réactionnels de
(A) des alcanols en C₁-C₃₀, des acides gras en C₈-C₂₂, des alkyl(en C₁-C₁₂)phénols ou des amines secondaires en C₂-C₃₀ avec
(B) au moins un oxyde d'alkylène en C₂-C₄ ou du tétrahydrofuranne, le rapport molaire (A) : (B) se situant dans la plage de 1 : 2 à 1 : 50,
et par hydrolyse des groupes anhydride des copolymères pour obtenir des groupes carboxyle ou leurs sels, l'estérification partielle des copolymères étant menée à un point tel que l'on obtient une estérification des groupes carboxyle du copolymère à concurrence d'une valeur entre 5 et 50 %.

5. Révélateur selon une ou plusieurs des revendications 1 à 4, **caractérisé en ce que** le rapport molaire (A) : (B) se situe dans la plage de 1 : 4 à 1 : 10.

6. Révélateur selon une ou plusieurs des revendications 1 à 5, **caractérisé en ce que** le copolymère faisant office d'émulsifiants contient en outre, jusqu'à concurrence de 50 mol %, des unités choisies parmi le groupe comprenant des amides d'acides carboxyliques en C₃-C₈ à insaturation monoéthylénique, dont les groupes amides répondent à la formule
-CO-N(R¹)(R²),
dans laquelle
R¹ représente un groupe alkyle en C₈-C₂₈ ou un groupe répondant à la formule RO-[CHR³-CHR⁴-O]ₙ₋₁-CHR³-CHR⁴-, et
R² représente un atome d'hydrogène ou un des groupes R¹,
R³, R⁴ sont identiques ou différents et représentent un atome d'hydrogène, un groupe méthyle ou un groupe éthyle,
R représente un groupe alkyle en C₁-C₂₈, et
n représente un nombre entier de 2 à 100.

7. Révélateur selon une ou plusieurs des revendications 1 à 6, **caractérisé en ce que** les copolymères présentent un poids moléculaire moyen M_{w} de 500 à 500.000, de préférence de 1.000 à 150.000.

8. Révélateur selon une ou plusieurs des revendications 1 à 7, **caractérisé en ce que** la fraction des copolymères s'élève de 0,1 à 10,0 % en poids, de préférence de 0,2 à 8,0 % en poids, de manière particulièrement préférée de 0,5 à 6,0 % en poids, chaque fois rapportés au poids total du révélateur.

9. Révélateur selon une ou plusieurs des revendications 1 à 8, **caractérisé en ce qu'**il contient en outre un solvant organique miscible à l'eau et au moins un composé tensioactif, le cas échéant également des substances tampons, des formateurs de complexes et/ou des agents antimousse.

10. Révélateur selon une ou plusieurs des revendications 1 à 9, **caractérisé en ce que** la fraction de l'agent réagissant à la manière des alcalis s'élève de 0,1 à 20 % en poids, de préférence de 0,5 à 10 % en poids, de manière particulièrement préférée de 1,0 à 5,0 % en poids, chaque fois rapportés au poids total du révélateur, l'agent réagissant à la manière des alcalis représentant de préférence une alcanolamine, un hydroxyde ou un carbonate, de manière particulièrement préférée l'éthanolamine, la diéthanolamine ou la triéthanolamine, l'isopropanolamine, la diisopropanolamine ou encore un hydroxyde de métal alcalin ou de métal alcalino-terreux.

11. Révélateur selon une ou plusieurs des revendications 1 à 10, **caractérisé en ce que** sa valeur de pH s'élève de 8,0 à 13,0, de préférence de 8,5 à 11,5.

12. Révélateur selon la revendication 9, **caractérisé en ce que** la fraction du solvant organique miscible à l'eau s'élève de 0,5 à 15,0 % en poids, de préférence de 1,0 à 10,0 % en poids, de manière particulièrement préférée de 2,0 à 6,0 % en poids, chaque fois rapportés au poids total du révélateur, le solvant organique miscible à l'eau représentant de préférence l'alcool benzylique, l'éther monophénylique d'éthylèneglycol, le 1-phényl-éthanol, le 2-phényl-éthanol ou encore l'éther monométhylique et monophénylique de propylèneglycol.

13. Mélange de révélateur selon la revendication 9, **caractérisé en ce que** la fraction du ou des composés tensioactifs s'élève de 0,2 à 12,0 % en poids, de préférence de 0,5 à 8,0 % en poids, de manière particulièrement préférée de 1,0 à 6,0 % en poids, chaque fois rapportés au poids total du révélateur, le composé tensioactif représentant de préférence un agent tensioactif anionique, de manière particulièrement préférée l'octylsulfate, le dodécylbenzène-sulfonate, un alkylphénoléthersulfate, le naphtalènesulfonate, le sulfosuccinate et/ou un alkylétherphosphate de métal alcalin, de préférence de sodium.

14. Utilisation du révélateur selon les revendications 1 à 13 pour le développement de matériaux d'enregistrement comprenant une couche photosensible exposée à traitement négatif, la couche à traitement négatif contenant, à titre de composant photosensible, de préférence (a) un composé de polycondensation d'un sel de diazonium, (b) une combinaison de composés à insaturation éthylénique polymérisables par voie radicalaire et de photoinitiateurs ou (c) un mélange de (a) et (b).

15. Utilisation selon la revendication 14, **caractérisé en ce que** la couche à traitement négatif contient un liant, de préférence un produit réactionnel d'un anhydride intramoléculaire d'un acide polycarboxylique organique avec un polymère synthétique contenant des groupes hydroxyle, qui ne contient pas d'autres groupes fonctionnels aptes à entrer en réaction avec des anhydrides d'acides.

## Claims

1. A developer for exposed, photosensitive recording materials which contains water and at least one compound which is alkaline in aqueous solution, which developer contains at least one copolymer acting as an emulsifier and comprising units of
(I) at least one hydrophobic vinyl compound which has at least one optionally substituted mono- or bicyclic (C₆-C₁₄)aryl radical and
(II) at least one hydrophilic, ethylenically unsaturated carboxylic acid, some of the carboxyl groups in these units being esterified with reaction products of
(A) (C₁-C₃₀)alkanols, (C₈-C₂₅)alkanoic acids, (C₁-C₁₂)-alkylphenols or di(C₁-C₂₀)alkylamines with
(B) (C₂-C₄)alkylene oxides or tetrahydrofuran,
the molar ratio (A):(B) being in the range from 1:2 to 1:50.

2. Developer according to claim 1, wherein from 5 to 50%, particularly preferably from 10 to 35%, of the carboxyl groups of the ethylenically unsaturated carboxylic acids (II) have been esterified.

3. Developer according to claim 1 or 2, wherein the units (I) and (II) together account for at least 50 mol%, preferably at least 70 mol%, of all monomer units in the copolymer, the units (II) accounting for an amount of at least 5 mol%, preferably at least 10 mol%.

4. Developer according to one or more of claims 1 to 3, wherein the copolymer acting as emulsifier is obtainable by copolymerization of (I) at least one compound having an optionally substituted phenyl group or a naphthyl group and
(IIa) at least one ethylenically unsaturated dicarboxylic anhydride having 4 to 8 carbon atoms, the molar ratio (I):(IIa) being in the range from 7:3 to 3:7, or
(IIb) at least one ethylenically unsaturated monocarboxylic acid having 3 to 8 carbon atoms, the molar ratio (I):(IIb) being in the range from 1:1 to 1:5,
subsequent partial esterification of the copolymer with reaction products of
(A) (C₁-C₃₀)alkanols, (C₈-C₂₂)fatty acids, (C₁-C₁₂)alkylphenols or secondary (C₂-C₃₀)amines with
(B) at least one (C₂-C₄)alkylene oxide or tetrahydrofuran, the molar ratio (A):(B) being in the range from 1:2 to 1:50,
and hydrolysis of the anhydride groups of the copolymers to carboxyl groups or salts thereof, the partial esterification of the copolymers being continued until between 5 and 50% of the carboxyl groups of the copolymer have been esterified.

5. Developer according to one or more of claims 1 to 4, wherein the molar ratio (A):(B) is in the range from 1:4 to 1:10.

6. Developer according to one or more of claims 1 to 5, wherein the copolymer acting as emulsifier additionally contains up to 50 mol% of units of amides of monoethylenically unsaturated (C₃-C₈)carboxylic acids, whose amido groups correspond to the formula
-CO-NR¹R²
in which
R¹ is a (C₈-C₂₈)alkyl group or a group of the formula RO-[CHR³-CHR⁴-O]ₙ₋₁-CHR³-CHR⁴- and
R² is a hydrogen atom or one of the groups R¹,
R³ and R⁴ are identical or different and are a hydrogen atom, a methyl group or an ethyl group,
R is a (C₁-C₂₈)alkyl group and
n is an integer from 2 to 100.

7. Developer according to one or more of claims 1 to 6, wherein the copolymers have an average molecular weight M_{w} of from 500 to 500,000, preferably from 1000 to 150,000.

8. Developer according to one or more of claims 1 to 7, wherein the amount of the copolymers is from 0.1 to 10.0% by weight, preferably from 0.2 to 8.0% by weight, particularly preferably from 0.5 to 6.0% by weight, based in each case on the total weight of the developer.

9. Developer according to one or more of claims 1 to 8, which additionally contains a water-miscible organic solvent and at least one surface-active compound, optionally also buffer substances, complexing agents and/or antifoams.

10. Developer according to one or more of claims 1 to 9, wherein the amount of the alkaline agent is from 0.1 to 20% by weight, preferably from 0.5 to 10% by weight, particularly preferably from 1.0 to 5.0% by weight, based in each case on the total weight of the developer, the alkaline agent preferably being an alkanolamine, a hydroxide or a carbonate, particularly preferably ethanolamine, di- or triethanolamine, isopropanolamine, diisopropanolamine or an alkali metal or alkaline earth metal hydroxide.

11. Developer according to one or more of claims 1 to 10, wherein its pH is from 8.0 to 13.0, preferably from 8.5 to 11.5.

12. Developer according to claim 9, wherein the amount of the water-miscible organic solvent is from 0.5 to 15.0% by weight, preferably from 1.0 to 10.0% by weight, particularly preferably from 2.0 to 6.0% by weight, based in each case on the total weight of the developer, the water-miscible organic solvent preferably being benzyl alcohol, ethylene glycol monophenyl ether, 1-phenylethanol, 2-phenylethanol or propylene glycol monomethyl or -phenyl ether.

13. Developer mixture according to claim 9, wherein the amount of the surface-active compound(s) is from 0.2 to 12.0% by weight, preferably from 0.5 to 8.0% by weight, particularly preferably from 1.0 to 6.0% by weight, based in each case on the total weight of the developer, the surface-active compound preferably being an anionic surfactant, particularly preferably an alkali metal, preferably sodium, octylsulfate, dodecylbenzenesulfonate, alkylphenolethersulfate, naphthalenesulfonate, sulfosuccinate and/or alkyletherphosphate.

14. The use of the developer according to any of claims 1 to 13 for developing recording materials having an exposed, photosensitive negative-working layer, the negative-working layer containing, as a photosensitive component, preferably (a) a diazonium salt polycondensation compound, (b) a combination of ethylenically unsaturated compounds capable of free radical polymerization and photoinitiators or (c) a mixture of (a) and (b).

15. Use according to claim 14, wherein the negative-working layer contains a binder, preferably a reaction product of an intramolecular anhydride of an organic polycarboxylic acid with a synthetic polymer containing hydroxyl groups, which contains no further functional groups capable of reacting with acid anhydrides.
